(19) Europäisches Patentamt
European Patent Office
Office européen des brevets

(11) **EP 2 959 302 B1**

(12) **FASCICULE DE BREVET EUROPEEN**

(45) Date de publication et mention de la délivrance du brevet:
**17.06.2020 Bulletin 2020/25**

(21) Numéro de dépôt: **14710026.7**

(22) Date de dépôt: **17.02.2014**

(51) Int Cl.:
*G01R 31/36* (2020.01)    *G01R 31/367* (2019.01)
*G01R 31/374* (2019.01)    *B60L 3/12* (2006.01)
*B60L 58/12* (2019.01)

(86) Numéro de dépôt international:
**PCT/FR2014/050328**

(87) Numéro de publication internationale:
**WO 2014/128396 (28.08.2014 Gazette 2014/35)**

(54) **EVALUATION DE L'ENERGIE EXTRACTIBLE D'UNE BATTERIE DE VEHICULE AUTOMOBILE**

ÜBERPRÜFUNG DER AUS EINER KRAFTFAHRZEUGBATTERIE EXTRAHIERBAREN ENERGIE

ASSESSMENT OF THE ENERGY THAT CAN BE EXTRACTED FROM A MOTOR VEHICLE BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2013 FR 1351488**

(43) Date de publication de la demande:
**30.12.2015 Bulletin 2015/53**

(73) Titulaire: **Renault S.A.S.**
**92100 Boulogne-Billancourt (FR)**

(72) Inventeurs:
• **SAINT-MARCOUX, Antoine**
**91120 Palaiseau (FR)**
• **MARCHAL, Caroline**
**78180 Montigny-le-Bretonneux (FR)**

(56) Documents cités:
**EP-A1- 1 972 955      EP-A1- 2 177 389
EP-A1- 2 184 800      WO-A1-2013/008814
DE-A1-102005 052 448      ES-A1- 2 247 896
FR-A1- 2 826 457      GB-A- 2 478 557
JP-A- H0 620 723      JP-A- 2001 110 459**

**US-A- 6 160 380      US-A1- 2005 001 627
US-A1- 2007 216 365      US-A1- 2008 234 956
US-A1- 2013 041 538      US-B1- 6 534 954**

• **JONGHOON KIM ET AL: "SOC/capacity estimation of a Li-Ion battery based on pattern recognition at different temperature", POWER ELECTRONICS AND ECCE ASIA (ICPE&ECCE), 2011 IEEE 8TH INTERNATIONAL CONFERENCE ON, IEEE, 30 mai 2011 (2011-05-30), pages 296-303, XP031956204, DOI: 10.1109/ICPE.2011.5944608 ISBN: 978-1-61284-958-4**
• **ANTONI SZUMANOWSKI ET AL: "Battery Management System Based on Battery Nonlinear Dynamics Modeling", IEEE TRANSACTIONS ON VEHICULAR TECHNOLOGY, IEEE SERVICE CENTER, PISCATAWAY, NJ, US, vol. 57, no. 3, 1 mai 2008 (2008-05-01), pages 1425-1432, XP011202304, ISSN: 0018-9545**
• **BARONTI F ET AL: "State-of-charge estimation enhancing of lithium batteries through a temperature-dependent cell model", APPLIED ELECTRONICS (AE), 2011 INTERNATIONAL CONFERENCE ON, IEEE, 7 septembre 2011 (2011-09-07), pages 1-5, XP032063421, ISBN: 978-1-4577-0315-7**

EP 2 959 302 B1

- **FENGCHUN SUN ET AL: "Adaptive unscented Kalman filtering for state of charge estimation of a lithium-ion battery for electric vehicles", ENERGY, PERGAMON PRESS, OXFORD, GB, vol. 36, no. 5, 22 mars 2011 (2011-03-22), pages 3531-3540, XP028204433, ISSN: 0360-5442, DOI: 10.1016/J.ENERGY.2011.03.059 [extrait le 2011-03-28]**

## Description

L'invention concerne le contrôle d'une batterie de véhicule automobile, en particulier l'évaluation de l'énergie disponible (en anglais « Available Energy ») dans une batterie de véhicule automobile notamment un véhicule électrique ou hybride.

Pour un état de charge ou SOC (de l'anglais « State of Charge ») donné, l'énergie extractible d'une batterie est fonction de la température car les pertes par effet Joule associées au déplacement des électrons dépendent fortement de la température. En effet, plus la température de batterie est faible, plus les résistances internes de la batterie sont élevées. Pour un même niveau de courant, la tension moyenne peut devenir plus faible pendant l'ensemble de la décharge.

Il est connu d'équiper les véhicules automobiles de systèmes de gestion de batterie, par exemple de BMS (de l'anglais « Battery Management System »), permettant entre autres d'évaluer l'énergie disponible en fonction notamment de la température extérieure.

Le document US 6,160,380 décrit ainsi un procédé pour estimer la capacité résiduelle d'une batterie, dans lequel on applique un facteur de correction fonction de la température, pour prendre en compte l'influence de la température extérieure.

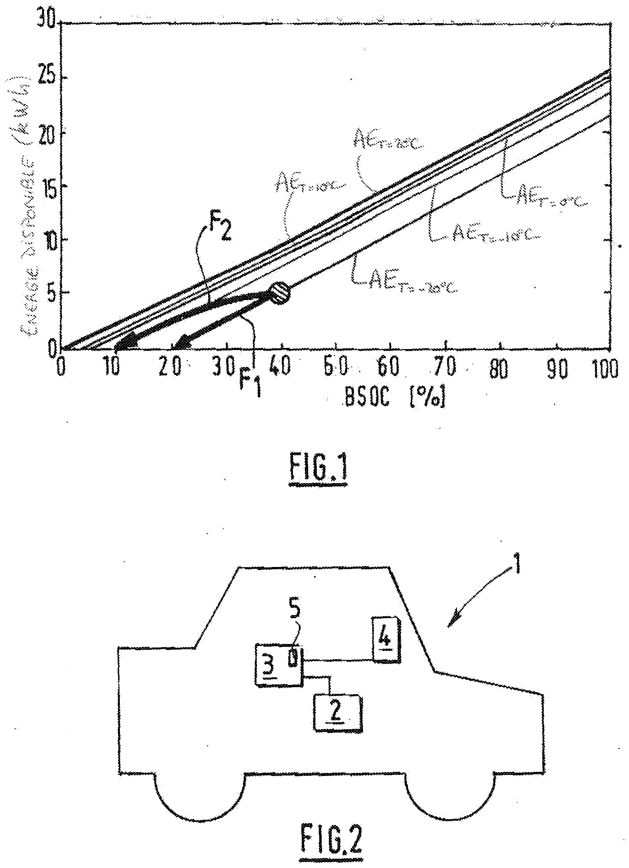

La figure 1 est un graphique montrant l'énergie disponible en fonction de l'état de charge de la batterie (BSOC de l'anglais « Battery State of Charge ») pour différentes valeurs de température. Chaque courbe $AE_{T=Ti}$ correspond à une température Ti, entre -20°C et +20°C. Il est possible, pour un état de charge et une température donnés, de lire la valeur d'énergie disponible, de la convertir en une valeur d'autonomie restante (distance que le client pourra parcourir avant la panne sèche), et d'afficher cette valeur afin que l'utilisateur en prenne connaissance. Dit autrement, on suppose qu'en cours de fonctionnement, on se déplace sur ce graphique suivant des déplacements du type de celui correspondant à la flèche F1.

Or, si la valeur de kilométrage affichée est peu fiable, le client risque d'être insatisfait. Si l'énergie disponible est sous-estimée, le client risque d'être dissuadé de prendre son véhicule, à tort. A contrario si l'énergie disponible est surestimée, le client risque la panne sèche en cours de mission. Il existe donc un besoin pour un procédé d'évaluation de l'énergie disponible qui permettrait d'améliorer la satisfaction du client.

Le document « SOC/capacity estimation of a Li-ion battery based on pattern recognition at différent températures » (JONGHOON Kim et al, POWER ELECTRONICS AND ECCE ASIA, IEEE 8TH INTERNATIONAL CONFERENCE, mai 2011, pages 296-303) décrit un procédé d'estimation de l'état de charge d'une batterie basé sur des filtres de Kalman.

Le document US 2008/234956 A1 décrit un procédé calcul de variables d'état d'une batterie secondaire, par exemple l'état de charge.

La présente invention concerne donc un procédé comme décrit dans la revendication 1 ainsi qu'un dispositif tel que décrit dans la revendication 6. Des réalisations avantageuses de l'invention sont également décrites dans les revendications dépendantes.

Il est proposé un procédé d'évaluation d'une quantité d'énergie extractible d'une batterie de véhicule automobile comprenant :

- recevoir une valeur initiale d'un paramètre de température et une valeur initiale d'un paramètre d'état de charge de la batterie, correspondant à un instant initial,
- estimer au moins une valeur ultérieure du paramètre de température, correspondant à au moins un instant à venir, en fonction de la valeur initiale du paramètre de température reçue et de la valeur initiale du paramètre d'état de charge reçue,
- déterminer une valeur estimée de la quantité d'énergie extractible de la batterie en fonction de cette au moins une valeur ultérieure du paramètre de température et de la valeur initiale du paramètre d'état de charge de la batterie.

On pourra prévoir de transmettre vers une interface utilisateur un signal élaboré en fonction de la valeur d'énergie extractible ainsi déterminée.

Ainsi, l'évaluation de l'énergie disponible fait intervenir une prédiction de la température ultérieure de la batterie. Dit autrement, plutôt que de considérer que la température du pack batterie reste constante alors que le véhicule est en roulage, on prend en compte le réchauffement associé à l'utilisation du véhicule. Ceci peut permettre une meilleure évaluation de l'énergie disponible, et une meilleure estimation de l'autonomie du véhicule automobile. En effet, pour revenir au graphique de la figure 1, il a été observé qu'en cours de roulage des déplacements sont davantage du type de celui correspondant à la flèche F2 que de celui de la flèche F1, du fait de la montée en température de la batterie pendant le roulage.

La satisfaction client sera donc vraisemblablement améliorée.

En particulier, dans l'art antérieur précité, en cas de température extérieure relativement basse, l'utilisateur ayant laissé son véhicule garé avec une batterie relativement peu chargée risque de voir affichée une valeur d'autonomie très faible (voire nulle), alors que, de fait, la batterie n'est pas vide.

En outre, dans l'art antérieur, à partir du moment où cette montée en température de la batterie n'est pas prise en compte, l'erreur sur l'estimation de l'énergie disponible dans la batterie peut varier selon que la température extérieure est relativement basse ou relativement élevée.

Le procédé décrit ci-dessus, en prenant ainsi en compte le la montée en température de la batterie, peut permettre de limiter ces erreurs d'appréciation de l'autonomie.

Le paramètre de température peut être la température, un paramètre proportionnel à la température, ou autre.

La valeur ultérieure de température peut être une valeur correspondant à un certain temps de roulage, une valeur moyennée de température sur une durée attendue de roulage, ou autre.

L'instant initial peut être un instant de début de mission, et le ou les instant(s) à venir peuvent être un ou des instants pendant un roulage supposé.

Le paramètre d'état de charge peut être le SOC, un paramètre permettant de déterminer le SOC, ou autre.

La valeur estimée de la quantité d'énergie extractible peut être une valeur d"énergie extractible, une valeur d'un paramètre permettant de déterminer l'énergie extractible, ou autre.

L'invention n'est en rien limitée par la façon dont on détermine la ou les valeurs de température ultérieure. Par exemple, on pourrait prévoir de lire une unique valeur de température dans une cartographie, en fonction de la valeur de température initiale et de l'état de charge.

Avantageusement et de façon non limitative, on peut prévoir de lire dans une mémoire une valeur d'un paramètre représentatif d'un courant de décharge conservée dans cette mémoire, cette valeur étant élaborée en fonction de valeurs mesurées au cours d'une ou plusieurs mission(s) précédente(s), par exemple en fonction de valeurs de courant de décharge mesurées au cours de précédents roulages.

Dit autrement, lors de précédentes phases de décharge de la batterie, on effectue un apprentissage de cette valeur de paramètre. Ceci peut permettre d'utiliser aux fins d'estimation de la valeur de température ultérieure, une valeur de paramètre représentatif du courant de décharge correspondant davantage aux types de conduite ou aux types de missions attendues.

Le paramètre représentatif d'un courant de décharge peut par exemple être une valeur de courant, une valeur quadratique de courant, un paramètre ayant une valeur proportionnelle à la valeur du courant, ou autre. L'invention n'est en rien limitée à la nature exacte de ce paramètre.

Par exemple, dans un mode de réalisation, on pourra prévoir une cartographie permettant d'associer une valeur de température moyenne à une valeur de température extérieure, un état de charge initial et un niveau moyen de la valeur quadratique du courant de décharge attendu.

Avantageusement et de façon non limitative, on peut prévoir de modéliser l'évolution de la température de la batterie au cours de la décharge en fonction du temps. Cette modélisation peut être fonction notamment de la valeur de la température initiale de la batterie reçue et/ou d'une valeur estimée de température en fin de décharge.

Avantageusement et de façon non limitative, on peut prévoir de modéliser l'évolution de l'état de charge de la batterie en fonction du temps.

Avantageusement et de façon non limitative, on peut prévoir de déterminer un instant de fin de décharge à partir au moins de la modélisation de l'évolution de la température en fonction du temps et éventuellement à partir de la modélisation de l'évolution de l'état de charge de la batterie en fonction du temps.

Avantageusement et de façon non limitative, on pourra prévoir d'estimer une valeur de température moyenne depuis un instant de début de décharge jusqu'à l'instant de fin de décharge ainsi déterminé.

L'invention n'est en rien limitée à l'estimation d'une seule valeur de température ultérieure. On pourrait prévoir de déterminer une pluralité de valeurs de températures ultérieures et de calculer l'énergie extractible en fonction de cette pluralité de valeurs.

Néanmoins, l'utilisation d'une seule valeur de température ultérieure peut permettre d'avoir recours à une cartographie pour déterminer la valeur d'énergie extractible.

Cette cartographie peut par exemple permettre d'associer une valeur d'énergie extractible à une valeur d'état de charge de la batterie initiale et à la valeur de température moyenne estimée.

Avantageusement et de façon non limitative, on peut prévoir d'estimer un état de santé, par exemple une valeur de paramètre SOH (de l'anglais « State Of Health ») de la batterie et de corriger la valeur d'énergie extractible obtenue en fonction de la valeur d'état de santé estimée.

Avantageusement et de façon non limitative, l'instant de fin de décharge peut être déterminé en partant du principe qu'en fin de décharge l'état de charge de la batterie est nul. La modélisation de l'évolution de l'état de charge de la batterie en fonction du temps peut alors permettre à elle seule de déterminer l'instant de fin de décharge.

Avantageusement et de façon non limitative, on peut partir de l'hypothèse que l'état de charge le plus bas qui peut être atteint par la batterie dépend linéairement de la température. L'estimation de l'instant de fin de décharge implique alors à la fois la modélisation de l'évolution de l'état de charge de la batterie en fonction du temps et la modélisation de l'évolution de la température en fonction du temps.

Avantageusement et de façon non limitative, on calcule un premier instant de fin de décharge en se basant sur une première hypothèse, selon laquelle en fin de décharge l'état de charge de la batterie est nul, et on calcule un deuxième instant de fin de décharge en partant d'une deuxième hypothèse, selon laquelle l'état de charge le plus bas qui peut être atteint par la batterie dépend linéairement de la température, puis on choisit l'instant de fin de décharge plus faible parmi ce premier et ce deuxième instant de fin de décharge.

Il est en outre proposé un dispositif d'évaluation d'une quantité d'énergie extractible d'une batterie de véhicule automobile, ce dispositif comprenant des moyens de réception aptes à recevoir une valeur initiale d'un paramètre de température et une valeur initiale d'un paramètre d'état de charge de la batterie, et des moyens de traitement agencés pour estimer au moins une valeur ultérieure d'un paramètre de température, à au moins un instant futur, en fonction des valeurs reçues des paramètres de température et d'état de charge, et pour déterminer une valeur estimée de quantité d'énergie extractible de la batterie en fonction de cette au moins une valeur ultérieure du paramètre de température et de la valeur initiale du paramètre d'état de charge de la batterie. Le dispositif peut en outre comprendre des moyens de transmission agencés pour transmettre vers une interface utilisateur un signal élaboré en fonction de la valeur d'énergie extractible ainsi déterminée.

Il est en outre proposé un système de gestion de batterie de véhicule automobile, par exemple un BMS ou autre, intégrant un tel dispositif.

Ce système et/ou ce dispositif peuvent comprendre ou être intégrés dans un ou plusieurs processeurs, par exemple des microcontrôleurs, des microprocesseurs ou autres.

Les moyens de réception peuvent comprendre une broche d'entrée, un port d'entrée ou autre. Les moyens de traitement peuvent par exemple comprendre un cœur de processeur ou CPU (de l'anglais « Central Processing Unit »). Les moyens de transmission peuvent par exemple comprendre un port de sortie, une broche de sortie ou autre.

Il est en outre proposé un véhicule automobile comprenant un système de gestion de batterie tel que décrit ci-dessus, et comprenant éventuellement une batterie. Ce véhicule peut par exemple être un véhicule électrique ou hybride.

Il est en outre proposé un produit programme d'ordinateur comprenant les instructions pour effectuer les étapes du procédé décrit ci-dessus lorsque ces instructions sont exécutées par un processeur.

L'invention sera mieux comprise en référence aux figures, lesquelles illustrent des modes de réalisation non limitatifs.

La figure 1, déjà commentée, est un graphique avec en abscisse l'état de charge de la batterie en %, et en ordonnée l'énergie disponible associée, et ce pour différentes valeurs de température.

La figure 2 montre un exemple de véhicule selon un mode de réalisation de l'invention.

La figure 3 est un organigramme d'un exemple de procédé selon un mode de réalisation de l'invention.

En référence à la figure 2 un véhicule automobile 1, par exemple un véhicule électrique, peut comprendre une batterie de traction 2 apte à tracter ce véhicule, un système de gestion de la batterie 3, dit BMS et une interface utilisateur 4, par exemple un tableau de bord.

Le BMS 3 permet de commander la charge et la décharge de la batterie 2, et permet de commander l'affichage de messages sur un écran (non représenté) de l'interface utilisateur 4.

Le BMS 3 intègre un dispositif 5 d'évaluation de l'énergie disponible dans la batterie 2, par exemple une partie d'un processeur. Ce dispositif 5 peut notamment être activé lorsque l'utilisateur met le contact afin de démarrer le véhicule, et également en cours de mission.

Le BMS 3 est en communication avec des capteurs de température (non représentés) et des dispositifs de mesure de tension et de courant, par exemple un ASIC de mesure de tension cellule et un ampèremètre non représentés.

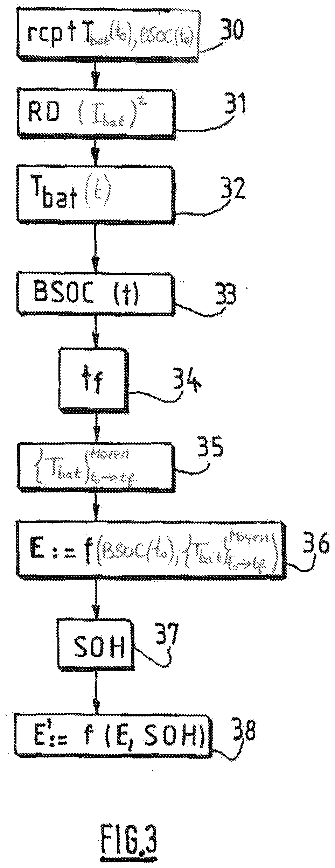

En référence à la figure 3, un procédé selon un mode de réalisation de l'invention peut comprendre une étape 30 consistant à recevoir une valeur de température initiale $T_{bat}(t_0)$ de la batterie, issue d'un capteur de température, et une valeur d'état de charge de la batterie initiale $BSOC(t_0)$. Cette valeur d'état de charge peut par exemple être issue d'un capteur de tension aux bornes de la batterie, ou bien de plusieurs capteurs aux bornes des cellules de la batterie.

Cette étape 30, et plus généralement le procédé de la figure 3, peut être effectuée en début de mission, suite à une détection d'un phénomène de début de mission, par exemple lorsque le conducteur a mis le contact ou ouvert la portière du véhicule.

Selon un mode de réalisation préférentiel, ce calcul peut être réalisé à intervalles réguliers (par exemple toutes les secondes).

Puis on lit dans une mémoire une valeur quadratique moyenne $(I_{BAT})^2$ du courant de décharge au cours d'une étape 31.

Cette valeur a été élaborée en fonction de valeurs mesurées au cours de missions précédentes. Par exemple, lors des phases de décharge de la batterie, le BMS peut calculer le niveau moyen de la valeur quadratique du courant de décharge.

Selon un premier mode de réalisation, en cours de roulage, le BMS peut calculer à chaque instant une valeur moyenne $(I_{BAT})^2$ sur les derniers kilomètres parcourus par le véhicule.

Selon un deuxième mode de réalisation, le BMS peut mesurer, sur une durée relativement longue avec un filtre passe-bas du premier ordre le terme $(I_{BAT})^2$.

Ces valeurs $(I_{BAT})^2$ pourront être utilisées pour modéliser un profil de température en fonction du temps, au cours d'une étape 32. Au cours de cette étape on met en œuvre l'équation suivante :

$$m \cdot C_p \cdot \frac{\partial T_{bat}}{\partial t} = R \cdot (I_{bat})^2 + \varepsilon - h \cdot S \cdot (T_{bat} - T_{ext}) \qquad (1)$$

dans lequel

$m$ représente la masse de la batterie, en kg,
$C_p$ représente la capacité calorifique de la batterie, en J/kg/K,
$T_{BAT}$ représente la température de la batterie, en °C,
$R$ représente la résistance interne de la batterie, en $\Omega$,
$I_{BAT}$ représente le courant qui traverse la batterie, en A,
$\varepsilon$ représente la chaleur créée par un système de réchauffage éventuellement présent dans la batterie, en W,
$h$ représente le coefficient de convection entre la batterie et l'extérieur, en W/m$^2$/K,
$S$ représente la surface d'échange avec l'extérieur, en m$^2$, et
$T_{ext}$ représente la température extérieure, en °C.

Dans ce mode de réalisation, on fait l'hypothèse que la résistance interne de la batterie $R$ varie suffisamment peu pour que l'on puisse conserver dans l'équation la valeur initiale de cette résistance, ou bien une valeur moyenne approximée.

On considère également que les paramètres $(I_{BAT})^2$, h et $\varepsilon$ sont constants. On peut alors caractériser la montée en température de la batterie à l'instant T avec l'équation suivante :

$$T_{bat}(t) = T_{bat}(t_0) + \Theta \cdot \left( 1 - e^{-\frac{(t-t_0)}{\tau}} \right) \qquad (2)$$

Avec :

$$\tau = \frac{m \cdot C_p}{h \cdot S}, \quad \text{et } \Theta \text{ fonction de la valeur de température initiale :}$$

$$\Theta = \frac{R \cdot (I_{bat})^2 + \varepsilon}{h \cdot S} + T_{ext} - T_{bat}(t_0) \qquad (3)$$

Puis on modélise l'évolution de l'état de charge de la batterie au cours du temps au cours d'une étape 33. Plus précisément, si l'on maintient l'hypothèse que le courant de décharge est constant, on peut alors estimer l'évolution de l'état de charge de la batterie selon l'équation :

$$BSOC(t) = BSOC(t_0) - \frac{I_{BAT}}{Q_{max}} \cdot (t - t_0) \qquad (4)$$

dans lequel

$BSOC$ représente le SOC de la batterie, en %,
$Q_{max}$ représente la capacité totale de la batterie, en A.h, et
$t_0$ représente l'instant de début de décharge.

On estime ensuite une valeur tf d'instant de fin de décharge, au cours d'une étape 34.

Plus précisément, on calcule un premier instant de fin de décharge $t_{f1}$ en partant d'une première hypothèse selon laquelle à la fin de la décharge l'état de charge de la batterie est nul. Dit autrement, en utilisant l'équation (4), il vient

$$t_{f1} = t_0 + \frac{BSOC(t_0) \cdot Q_{max}}{I_{BAT}} \qquad (5)$$

On détermine ensuite un deuxième instant de fin de décharge $t_{f2}$, cette fois en partant de l'hypothèse que l'énergie disponible pour le client est nulle lorsque l'état de charge atteint un seuil qui dépend linéairement de la température, c'est à dire que l'état de charge à cet instant de fin de décharge dépend linéairement de la température, selon :

$$BSOC(t_{f2}) = A - B \times T_{Bat} \qquad (6)$$

avec A et B constantes.

En couplant les équations 2, 4, et 6 on obtient :

$$BSOC(t_{f2}) = BSOC(t_0) - \frac{I_{BAT}}{Q_{max}} \cdot (t_{f2} - t_0)$$

$$= A - B \times \left\{ T_{bat}(t_0) + \Theta \cdot \left( 1 - e^{-\frac{(t_{f2}-t_0)}{\tau}} \right) \right\} \qquad (7)$$

Le deuxième instant de fin de décharge $t_{f2}$ est déterminé à partir de cette équation (7).

On choisit ensuite, parmi ces deux instants de fin de décharge $t_{f1}$, $t_{f2}$, l'instant de fin de décharge ayant la plus faible valeur.

A présent, connaissant la modélisation de l'évolution de la température de la batterie en fonction du temps et l'instant de fin de décharge attendu, on peut calculer une valeur de température moyenne $\{T_{bat}\}_{t_0 \to t_f}^{Moyen}$ entre l'instant de début de décharge $t_0$ et l'instant de fin de décharge $t_f$, au cours d'une étape 35. Plus précisément, on pourra mettre en œuvre une intégration : $\{T_{bat}\}_{t_0 \to t_f}^{Moyen} = \frac{1}{t_f - t_0} \int_{u=t_0}^{t_f} T_{bat}(u).du$ , soit, en couplant avec l'équation (2) :

$$\{T_{bat}\}_{t_0 \to t_f}^{Moyen} = T_{bat}(t_0) + \Theta - \frac{\Theta \cdot \tau}{(t_f - t_0)} \cdot \left( 1 - e^{-\frac{(t_f - t_0)}{\tau}} \right)$$

Puis au cours d'une étape 36 on lit dans une cartographie la valeur d'énergie extractible associée à la valeur de charge reçue à l'étape 30 et à la valeur de température moyenne $\{T_{bat}\}_{t_0 \to t_f}^{Moyen}$ déterminée à l'étape 35. Cette cartographie a été élaborée à partir d'une batterie neuve, par exemple en atelier.

Afin de prendre en compte les effets du vieillissement de la batterie, on peut prévoir, de déterminer, au cours d'une étape 37 et selon des moyens connus en soi de l'homme du métier, un état de santé de la batterie SOH, puis de corriger la valeur d'énergie extractible en fonction de la valeur d'énergie déterminée à l'étape 36, et de l'état de santé déterminé à l'étape 37. Par exemple, on multiplie la valeur d'énergie obtenue à l'étape 36 par le coefficient SOH de l'état de dégradation de la batterie.

Ainsi en prenant en compte la montée en température prévisible pour une décharge complète de la batterie, on peut estimer l'énergie extractible de la batterie de façon plus fiable que dans l'art antérieur.

Ce procédé peut ainsi permettre d'obtenir une estimation de l'autonomie du véhicule moins pessimiste que dans l'art antérieur, notamment lorsque la température extérieure est relativement basse. Ce procédé implique toutefois une connaissance a priori d'un modèle des échanges thermiques de la batterie. Il est donc préférable de procéder à des essais de caractérisation de ces échanges thermiques en atelier.

Le procédé décrit ci-dessus peut également être mis en œuvre lorsque le véhicule est équipé d'un dispositif de chauffage de la batterie. On adapte alors la modélisation de l'évolution de la température de la batterie en fonction du temps afin de prendre en compte ce réchauffage. En particulier, on pourra prévoir de déterminer le coût énergétique associé au réchauffage, de déterminer le gain en termes d'énergie extractible en cas de réchauffage, et de n'effectuer le réchauffage que si le gain est supérieur au coût.

**Revendications**

1. Procédé d'évaluation d'une quantité d'énergie extractible d'une batterie de véhicule automobile, le procédé étant exécuté par un processeur (5), comprenant :

   - recevoir (30) une valeur initiale d'un paramètre de température ($T_{bat}(t_0)$ ) et une valeur initiale d'un paramètre d'état de charge de la batterie ($BSOC(t_0)$), correspondant à un instant initial ($t_0$),
   - lire (31) une valeur d'un paramètre représentatif d'un courant de décharge de la batterie (($I_{BAT}$)$^2$) conservée en mémoire, ladite valeur étant élaborée en fonction de valeurs de courant de décharge mesurées au cours d'au moins une mission précédente du vehicule,
   - estimer (31) au moins une valeur ultérieure du paramètre de température, correspondant à au moins un instant à venir, en utilisant une étape de modélisation (32) de l'évolution du paramètre de température de la batterie au cours de la décharge en fonction du temps (Tbat(t)), en fonction de la valeur du paramètre de température initiale (Tbat(t0)) de la batterie reçue et de la dite valeur d'un paramètre représentatif d'un courant de décharge de la batterie (($I_{BAT}$)$^2$),
   - estimer (33, 34, 35) une valeur de paramètre de température moyenne (($Tbat)_{t0 \rightarrow tf}$$^{Moyen}$) depuis un instant initial (to) jusqu'à un instant de fin de décharge ($t_f$) en fonction de ladite modélisation (32) de l'évolution de la température de la batterie en fonction du temps; et
   - déterminer (36, 38) une valeur estimée de la quantité d'énergie extractible (E) de la batterie en fonction de ladite valeur de paramètre de température moyenne (($T_{bat})_{t0 \rightarrow tf}$$^{Moyen}$) et de la valeur initiale du paramètre d'état de charge de la batterie ($BSOC(t_0)$)..

2. Procédé selon la revendication 1, dans lequel on modélise l'évolution du paramètre de température de la batterie selon la formule suivante :

$$T_{bat}\big(t\big) = T_{bat}\big(t_0\big) + \Theta \cdot \left( 1 - e^{-\frac{(t-t_0)}{\tau}} \right),$$

Dans laquelle :

$t$ représente le temps,
$t_0$ représente l'instant initial,
$T_{BAT}(t)$ représente la température modélisée de la batterie,
$T_{BAT}(t_0)$ représente la valeur de température initiale reçue,
$\Theta$ est une constante déterminée en fonction de la valeur de la température initiale reçue, et
$\tau$ est une constante.

3. Procédé selon l'une des revendications 1 à 2, comprenant une étape consistant à déterminer (34) un instant de fin de décharge ($t_f$) à partir au moins de la modélisation de l'évolution du paramètre de température en fonction du temps.

4. Procédé selon la revendication 3, comprenant :

calculer un premier instant de fin de décharge en se basant sur une première hypothèse, selon laquelle en fin de décharge l'état de charge de la batterie est nul,
calculer un deuxième instant de fin de décharge en partant d'une deuxième hypothèse, selon laquelle l'état de charge le plus bas qui peut être atteint par la batterie en fin de décharge dépend linéairement de la température,
choisir l'instant de fin de décharge le plus faible parmi ce premier et ce deuxième instant de fin de décharge.

5. Procédé selon l'une des revendications 1 à 4, comprenant une étape de modélisation (33) de l'évolution du paramètre d'état de charge de la batterie ($BSOC(t)$) en fonction du temps.

6. Dispositif d'évaluation (5) d'une quantité d'énergie extractible d'une batterie (2) de véhicule automobile (1), le dispositif étant configuré pour la mise en œuvre du procédé selon l'une des revendications 1 à 5, le dispositif comprenant :

des moyens de réception aptes à recevoir une valeur initiale d'un paramètre de température et une valeur initiale d'un paramètre d'état de charge de la batterie, correspondant à un instant initial, et
des moyens de traitement agencés pour estimer au moins une valeur ultérieure du paramètre de température, correspondant à au moins un instant futur, en fonction des valeurs reçues des paramètres de température et d'état de charge, et agencés pour déterminer une valeur estimée de la quantité d'énergie extractible de la batterie en fonction de ladite au moins une valeur ultérieure du paramètre de température et de la valeur initiale du paramètre d'état de charge de la batterie.

7. Véhicule automobile (1) comprenant une batterie (2) et un dispositif selon la revendication 6 d'évaluation (5) d'une quantité d'énergie extractible de ladite batterie.

**Patentansprüche**

1. Verfahren zur Bewertung einer aus einer Kraftfahrzeugbatterie extrahierbaren Energiemenge, wobei das Verfahren von einem Prozessor (5) ausgeführt wird, das enthält:

- Empfangen (30) eines Ausgangswerts eines Temperaturparameters ($T_{bat}(t_0)$) und eines Ausgangswerts eines Ladezustandsparameters der Batterie ($BSOC(t_0)$), entsprechend einem Ausgangszeitpunkt ($t_0$),
- Lesen (31) eines gespeicherten Werts eines für einen Entladestrom der Batterie (($I_{BAT}$)$^2$) repräsentativen Parameters, wobei der Wert abhängig von Entladestromwerten erarbeitet wird, die während mindestens einer vorhergehenden Fahrt des Fahrzeugs gemessen wurden,
- Schätzen (31) mindestens eines späteren Werts des Temperaturparameters, entsprechend mindestens einem zukünftigen Zeitpunkt, unter Verwendung eines Modellierungsschritts (32) der Entwicklung des Temperaturparameters der Batterie während des Entladens abhängig von der Zeit (Tbat(t)), abhängig vom empfangenen Wert des Ausgangstemperaturparameters (Tbat(t0)) der Batterie und vom Wert eines für einen Entladestrom der Batterie (($I_{BAT}$)$^2$) repräsentativen Parameters,
- Schätzen (33, 34, 35) eines mittleren Temperaturparameterwerts (($Tbat$)$_{t0 \to tf}$$^{Mittel}$) von einem Ausgangszeitpunkt ($t_0$) bis zu einem Entladungsendezeitpunkt ($t_f$) abhängig von der Modellierung (32) der Entwicklung der Temperatur der Batterie abhängig von der Zeit; und
- Bestimmen (36, 38) eines geschätzten Werts der aus der Batterie extrahierbaren Energiemenge (E) abhängig vom mittleren Temperaturparameterwert (($T_{bat}$)$_{t0 \to tf}$$^{Mittel}$) und vom Ausgangswert des Ladezustandsparameters der Batterie ($BSOC(t_0)$).

2. Verfahren nach Anspruch 1, wobei die Entwicklung des Temperaturparameters der Batterie gemäß der folgenden Formel modelliert wird:

$$T_{bat}(t) = T_{bat}(t_0) + \Theta \cdot \left(1 - e^{\frac{(t-t_0)}{\tau}}\right),$$

in der:

t die Zeit darstellt,
$t_0$ den Ausgangszeitpunkt darstellt,
$T_{BAT}(t)$ die modellierte Temperatur der Batterie darstellt,
$T_{BAT}(t_0)$ den empfangenen Ausgangstemperaturwert darstellt,
$\Theta$ eine abhängig vom empfangenen Wert der Ausgangstemperatur bestimmte Konstante ist, und
$\tau$ eine Konstante ist.

3. Verfahren nach einem der Ansprüche 1 bis 2, das einen Schritt enthält, der darin besteht, einen Entladungsendezeitpunkt ($t_f$) ausgehend mindestens von der Modellierung der Entwicklung des Temperaturparameters abhängig von der Zeit zu bestimmen (34) .

4. Verfahren nach Anspruch 3, das enthält:

Berechnen eines ersten Entladungsendezeitpunkts auf der Basis einer ersten Hypothese, gemäß der der Ladezustand der Batterie am Ende der Entladung Null ist,
Berechnen eines zweiten Entladungsendezeitpunkts ausgehend von einer zweiten Hypothese, gemäß der der niedrigste Ladezustand, der von der Batterie am Ende der Entladung erreicht werden kann, linear von der Temperatur abhängt,
Wählen des schwächsten Entladungsendezeitpunkts unter diesem ersten und diesem zweiten Entladungsendezeitpunkt.

5. Verfahren nach einem der Ansprüche 1 bis 4, das einen Schritt der Modellierung (33) der Entwicklung des Ladezustandsparameters der Batterie (BSOC(t)) abhängig von der Zeit enthält.

6. Vorrichtung zur Bewertung (5) einer aus einer Batterie (2) eines Kraftfahrzeugs (1) extrahierbaren Energiemenge, wobei die Vorrichtung zur Durchführung des Verfahrens nach einem der Ansprüche 1 bis 5 konfiguriert ist, wobei die Vorrichtung enthält:

Empfangseinrichtungen, die einen Ausgangswert eines Temperaturparameters und einen Ausgangswert eines Ladezustandsparameters der Batterie entsprechend einem Ausgangszeitpunkt empfangen können, und Verarbeitungseinrichtungen, die eingerichtet sind, um mindestens einen späteren Wert des Temperaturparameters zu schätzen, der mindestens einem zukünftigen Zeitpunkt entspricht, abhängig von den empfangenen Werten der Temperatur- und Ladezustandsparameter, und eingerichtet sind, um einen geschätzten Wert der aus der Batterie extrahierbaren Energiemenge abhängig von dem mindestens einen späteren Wert des Temperaturparameters und dem Ausgangswerts des Ladezustandsparameters der Batterie zu bestimmen.

7. Kraftfahrzeug (1), das eine Batterie (2) und eine Vorrichtung nach Anspruch 6 zur Bewertung (5) einer aus der Batterie extrahierbaren Energiemenge enthält.

**Claims**

1. Method for assessing a quantity of energy that can be extracted from a motor vehicle battery, the method being executed by a processor (5), comprising:

- receiving (30) an initial value of a temperature parameter ($T_{bat}(t_0)$) and an initial value of a battery state-of-charge parameter ($BSOC(t_0)$), corresponding to an initial instant ($t_0$),
- reading (31) a value of a parameter representative of a battery discharge current (($I_{BAT})^2$) retained in memory, said value being generated as a function of discharge current values measured during at least one previous journey of the vehicle,
- estimating (31) at least one subsequent value of the temperature parameter, corresponding to at least one future instant, by using a step of modelling (32) of the trend of the temperature parameter of the battery during the discharge as a function of time (Tbat(t)), as a function of the value of the initial temperature parameter (Tbat(t0)) of the battery received and of said value of a parameter representative of a battery discharge current (($I_{BAT})^2$),
- estimating (33, 34, 35) an average temperature parameter value (($T_{bat})_{t0 \to tf}{}^{Average}$) from an initial instant ($t_0$)

to an end-of-discharge instant ($t_f$) as a function of said modelling (32) of the trend of the temperature of the battery as a function of time; and

- determining (36, 38) an estimated value of the quantity of energy that can be extracted (E) from the battery as a function of said average temperature parameter value (($T_{bat}$) $_{t0 \rightarrow tf}$$^{Average}$) and of the initial value of the battery state-of-charge parameter (BSOC($t_0$)).

2. Method according to Claim 1, in which the trend of the temperature parameter of the battery is modelled according to the following formula:

$$T_{bat}(t) = T_{bat}(t_0) + \Theta \cdot \left(1 - e \frac{(t - t_0)}{\tau}\right)$$

in which:

$t$ represents the time,
$t_0$ represents the initial instant,
$T_{BAT}(t)$ represents the model temperature of the battery,
$T_{BAT}(t_0)$ represents the initial temperature value received,
$\Theta$ is a constant determined as a function of the initial temperature value received, and
$\tau$ is a constant.

3. Method according to one of Claims 1 and 2, comprising a step consisting in determining (34) an end-of-discharge instant ($t_f$) from at least the modelling of the trend of the temperature parameter as a function of time.

4. Method according to Claim 3, comprising:

calculating a first end-of-discharge instant based on a first assumption, according to which, at the end of discharge, the state of charge of the battery is zero,
calculating a second end-of-discharge instant starting from a second assumption, according to which the lowest state of charge which can be reached by the battery at the end of discharge depends linearly on the temperature, choosing the lowest end-of-discharge instant from this first and this second end-of-discharge instant.

5. Method according to one of Claims 1 to 4, comprising a step of modelling (33) of the trend of the battery state-of-charge parameter (*BSOC(t)*) as a function of time.

6. Device for assessing (5) a quantity of energy that can be extracted from a motor vehicle (1) battery (2) the device being configured to implement the method according to one of Claims 1 to 5, the device comprising:

reception means that can receive an initial value of a temperature parameter and an initial value of a battery state-of-charge parameter, corresponding to an initial instant, and
processing means arranged to estimate at least one subsequent value of the temperature parameter, corresponding to at least one future instant, as a function of the received values of the temperature and state-of-charge parameters, and arranged to determine an estimated value of the quantity of energy that can be extracted from the battery as a function of said at least one subsequent value of the temperature parameter and of the initial value of the battery state-of-charge parameter.

7. Motor vehicle (1) comprising a battery (2) and a device according to Claim 6 for assessing (5) a quantity of energy that can be extracted from said battery.

FIG.1

FIG.2

rcpt $T_{bat}(t_0), BSOC(t_0)$  — 30

$RD\ (I_{bat})^2$  — 31

$T_{bat}(t)$  — 32

BSOC (t)  — 33

$t_f$  — 34

$\{T_{bat}\}_{t_0 \to t_f}^{Moyen}$  — 35

$E := f\left(BSOC(t_0), \{T_{bat}\}_{t_0 \to t_f}^{Moyen}\right)$  — 36

SOH  — 37

$E' := f(E, SOH)$  — 38

FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6160380 A

- US 2008234956 A1

**Littérature non-brevet citée dans la description**

- POWER ELECTRONICS AND ECCE ASIA. **JONG-HOON KIM et al.** IEEE 8TH INTERNATIONAL CONFERENCE. Mai 2011, 296-303